# EUROPEAN PATENT APPLICATION

(11) **EP 4 297 032 A1**
(43) Date of publication of application: **27.12.2023**
(21) Application number: 21929649.8
(22) Date of filing: 12.03.2021
(51) Int. Cl.: G11C 5/14, G06F 1/26, H02J 7/36, H02J 7/34

(54) **STORAGE DEVICE AND POWER SUPPLY CONTROL METHOD THEREFOR, AND ELECTRONIC DEVICE**

(71) Applicant: Huawei Technologies Co., Ltd., Shenzhen, Guangdong 518129 (CN)
(72) Inventor: JI, Bingwu, Shenzhen, Guangdong 518129 (CN); KOU, Kou, Shenzhen, Guangdong 518129 (CN); ZHAO, Tanfu, Shenzhen, Guangdong 518129 (CN); WANG, Yunpeng, Shenzhen, Guangdong 518129 (CN)
(74) Representative: Gill Jennings & Every LLP
(86) International application number: PCT/CN2021/080589
(87) International publication number: WO 2022/188176

(57) **Abstract**

This application provides a storage device, a power supply control method thereof, and an electronic device, and relates to the field of electronic technologies, to resolve read disturb in a conventional technology caused by an excessively large voltage difference between two voltages in a dual voltage domain of a memory. The storage device includes a voltage detection circuit, a power supply switching circuit, a peripheral logic unit circuit, and a bit cell circuit. The peripheral logic unit circuit is powered by a first power supply, and the bit cell circuit of the memory is powered by a power supply voltage obtained by the power supply switching circuit, that is, a power supply with a larger voltage between the first power supply and the second power supply is used to supply power. In this way, the storage device can meet a power consumption benefit when a voltage of the first power supply is relatively low and avoid read disturb, and can further ensure that a read/write speed is improved in a high voltage range, improving performance and reliability of the memory.

## Description

### TECHNICAL FIELD

This application relates to the field of electronic technologies, and in particular, to a storage device, a power supply control method thereof, and an electronic device.

### BACKGROUND

Currently, for a memory (memory), a dual voltage domain manner is used, so that a system works at a low voltage when being in a small program application or a power saving mode to reduce power consumption, or a system works at a high voltage when being in an application requiring high performance to meet a requirement of high frequency. When the memory works, a working voltage of the memory is configured with different voltage differences based on different application scenarios of a storage system.

However, in a current design of a dual power supply domain, when data is read from a bit cell of the memory, data in the bit cell may be overturned, and read disturb (read disturb) may occur. Consequently, stored data is lost, and reliability of the memory is low.

### SUMMARY

This application provides a storage device, a power supply control method thereof, and an electronic device, to resolve read disturb in a conventional technology caused by an excessively large voltage difference between two voltages in a dual voltage domain of a memory, so as to improve performance and reliability of the storage device.

According to a first aspect, this application provides a storage device. The storage device includes a voltage detection circuit, a power supply switching circuit, a peripheral logic unit circuit, and a bit cell circuit. The peripheral logic unit circuit is connected to a first power supply, and the bit cell circuit is connected to an output of the power supply switching circuit. The voltage detection circuit is connected to the first power supply and a second power supply, and is configured to compare a voltage value of the first power supply with a voltage value of the second power supply, and output a first conversion signal based on a comparison result. An input of the power supply switching circuit is connected to an output of the voltage detection circuit, and the power supply switching circuit is connected to the first power supply and the second power supply. When a voltage of the first power supply is greater than a voltage of the second power supply, the first conversion signal is used to control an output voltage of the power supply switching circuit to be the voltage of the first power supply. When the voltage of the first power supply is less than the voltage of the second power supply, the first conversion signal is used to control the output voltage of the power supply switching circuit to be the voltage of the second power supply.

Based on the foregoing storage device, the peripheral logic unit circuit is connected to the first power supply, and is powered by the first power supply. The bit cell circuit is connected to the output of the power supply switching circuit, that is, a power supply voltage of the bit cell circuit is a power supply voltage obtained by the power supply switching circuit, that is, a power supply with a larger voltage in the first power supply and the second power supply is used to supply power. When the voltage of the first power supply is less than the voltage of the second power supply, the first power supply supplies power to the peripheral logic unit circuit, and the second power supply supplies power to the bit cell circuit, so as to reduce power consumption of the logical power supply circuit in the storage device, and improve a power consumption benefit of the storage device. When the voltage of the first power supply is greater than the voltage of the second power supply, both the peripheral logic unit circuit and the bit cell circuit work at the voltage of the first power supply, so that it can be ensured that no read disturb occurs, and it can be ensured that a read/write speed is improved in a high voltage range, thereby improving performance and reliability of the storage device.

Further, the power supply switching circuit includes a first field effect transistor, a second field effect transistor, a third field effect transistor, and a fourth field effect transistor. A drain of the second field effect transistor is connected to a source of the fourth field effect transistor, and a drain of the third field effect transistor is connected to a source of the first field effect transistor. A source of the second field effect transistor is connected to the first power supply, and a source of the third field effect transistor is connected to the second power supply. Both a drain of the first field effect transistor and a drain of the fourth field effect transistor are connected to the output of the power supply switching circuit. When the voltage of the first power supply is greater than the voltage of the second power supply, the first field effect transistor is controlled to be turned off, the second field effect transistor is controlled to be turned on, the third field effect transistor is controlled to be turned off, and the fourth field effect transistor is controlled to be turned on. When the voltage of the first power supply is less than the voltage of the second power supply, the first field effect transistor is controlled to be turned on, the second field effect transistor is controlled to be turned off, the third field effect transistor is controlled to be turned on, and the fourth field effect transistor is controlled to be turned off. In this way, when the voltage of the first power supply is less than the voltage of the second power supply, the output voltage of the power supply switching circuit is the voltage of the second power supply, thereby reducing power consumption of the peripheral logic unit circuit in the storage device. When the voltage of the first power supply is greater than the voltage of the second power supply, the output voltage of the power supply switching circuit is the voltage of the first power supply, so that a voltage boosting and frequency increasing requirement of the peripheral logic unit circuit can be ensured, and read disturb caused when a working voltage of the peripheral logic unit circuit is higher than a working power supply of the bit cell circuit can be avoided, thereby improving performance and reliability of the storage device.

Optionally, a gate of the first field effect transistor is connected to the first conversion signal output by the voltage detection circuit, a gate of the second field effect transistor is connected to a second conversion signal, a gate of the third field effect transistor is connected to a third conversion signal, and a gate of the fourth field effect transistor is connected to a fourth conversion signal; and the third conversion signal is obtained by converting the first conversion signal from a voltage domain of the first power supply to a voltage domain of the second power supply by using a voltage conversion unit, the second conversion signal is a phase-inverted signal of the first conversion signal, and the fourth conversion signal is a phase-inverted signal of the third conversion signal. In this way, the first conversion signal can control the entire power supply switching circuit to implement the foregoing control function.

Optionally, well potentials of the first field effect transistor and the second field effect transistor may both be connected to the first power supply. Well potentials of the third field effect transistor and the fourth field effect transistor may both be connected to the second power supply. In this way, the well potential division may be simpler, and an area of a circuit chip of the storage device may be saved.

Optionally, the well potentials of the first field effect transistor and the fourth field effect transistor may both be connected to the output of the power supply switching circuit. The well potential of the second field effect transistor may be connected to the first power supply; and the well potential of the third field effect transistor may be connected to the second power supply. In this way, it can be ensured that the well potentials of the first field effect transistor and the fourth field effect transistor are always connected to a higher potential of the first power supply and the second power supply, thereby effectively avoiding latch up (latch up) that occurs when the well potentials of the first field effect transistor and the fourth field effect transistor are positively biased to a PN junction between the sources and the drains of the first field effect transistor and the fourth field effect transistor, and improving performance and reliability of the storage device.

Optionally, the power supply switching circuit may further include a fifth field effect transistor, a gate of the fifth field effect transistor is connected to a control signal, a source of the fifth field effect transistor is connected to the second power supply, and a drain of the fifth field effect transistor is connected to an output of the voltage conversion unit. If the first power supply fails, the control signal controls the fifth field effect transistor to be turned on, to enable the output of the power supply switching circuit to be the voltage of the first power supply. In this way, when the first power supply fails, the first power supply may be connected to the output of the power supply switching circuit by using the control signal, and the output of the power supply switching circuit and the first power supply are in a power-off state synchronously, thereby avoiding a problem that stability of the power supply switching circuit is reduced due to an excessively large leakage (leakage) current.

Optionally, the power supply switching circuit may further include a fifth field effect transistor, a gate of the fifth field effect transistor is connected to a control signal, a source of the fifth field effect transistor is connected to the second power supply, and a drain of the fifth field effect transistor is connected to an output of the voltage conversion unit by using a first phase inverter. If the first power supply fails, the control signal controls the fifth field effect transistor to be turned on, to enable the output of the power supply switching circuit to be the voltage of the second power supply. In this way, when the first power supply fails, the second power supply may be connected to the output of the power supply switching circuit by using the control signal; and when the second power supply fails, the second power supply is connected to the output of the power supply switching circuit by configuring the first conversion signal, so that the output of the power supply switching circuit and the second power supply are in a power-off state synchronously, thereby improving reliability and stability of the circuit.

Optionally, the second conversion signal is output by a second phase inverter based on the first conversion signal.

Optionally, the fourth conversion signal is output by a third phase inverter based on the third conversion signal.

Optionally, the power supply switching circuit further includes a buffer, where an input of the buffer is connected to the first conversion signal, and an output of the buffer is connected to an input of the second phase inverter or the gate of the first field effect transistor. In this way, the value of the first conversion signal can be buffered, so as to be input to the first field effect transistor and the second phase inverter, thereby improving reliability of the circuit.

According to a second aspect, this application provides an electronic device. The electronic device includes a storage device and a processing chip. The storage device is coupled to the processing chip, and the storage device is any possible storage device in the first aspect.

According to a third aspect, this application provides a power supply control method for a storage device, applied to any possible storage device in the first aspect. The method includes: A voltage detection circuit compares a voltage value of a first power supply with a voltage value of a second power supply, and outputs a first conversion signal. When a voltage of the first power supply is greater than a voltage of the second power supply, the first conversion signal controls an output voltage of a power supply switching circuit to be the voltage of the first power supply. When the voltage of the first power supply is less than the voltage of the second power supply, the first conversion signal controls the output voltage of the power supply switching circuit to be the voltage of the second power supply. The voltage of the first power supply is used as a power supply voltage of a peripheral logic unit circuit, and use the output voltage of the power supply switching circuit as a power supply voltage of the bit cell circuit.

Further, the power supply switching circuit includes: a first field effect transistor, a second field effect transistor, a third field effect transistor, and a fourth field effect transistor. A gate of the first field effect transistor is connected to the first conversion signal output by the voltage detection circuit, a gate of the second field effect transistor is connected to a second conversion signal, a gate of the third field effect transistor is connected to a third conversion signal, and a gate of the fourth field effect transistor is connected to a fourth conversion signal. A drain of the second field effect transistor is connected to a source of the fourth field effect transistor, and a drain of the third field effect transistor is connected to a source of the first field effect transistor. A source of the second field effect transistor is connected to the first power supply, and a source of the third field effect transistor is connected to the second power supply. Both a drain of the first field effect transistor and a drain of the fourth field effect transistor are connected to the output of the power supply switching circuit. The controlling, by the first conversion signal, an output voltage of the power supply switching circuit to be the voltage of the first power supply may include: The first conversion signal controls the first field effect transistor to be turned off, the second conversion signal controls the second field effect transistor to be turned on, the third conversion signal controls the third field effect transistor to be turned off, and the fourth conversion signal controls the fourth field effect transistor to be turned on. The first power supply is switched to the output of the power supply switching circuit, to enable the output of the power supply switching circuit to be the voltage of the first power supply. The controlling, by the first conversion signal, the output voltage of the power supply switching circuit to be the voltage of the second power supply may include: The first conversion signal controls the first field effect transistor to be turned on, the second conversion signal controls the second field effect transistor to be turned off, the third conversion signal controls the third field effect transistor to be turned on, and the fourth conversion signal controls the fourth field effect transistor to be turned off. The second power supply is switched to the output of the power supply switching circuit, to enable the output of the power supply switching circuit to be the voltage of the second power supply.

Optionally, the power supply switching circuit may further include a fifth field effect transistor, a gate of the fifth field effect transistor is connected to a control signal, a source of the fifth field effect transistor is connected to the second power supply, and a drain of the fifth field effect transistor is connected to an output of the voltage conversion unit and outputs a third conversion signal. The power supply control method may further include: The control signal controls, if the first power supply fails, the fifth field effect transistor to be turned on, to enable the first power supply to be switched to the output of the power supply switching circuit, to enable the output of the power supply switching circuit is the voltage of the first power supply.

Optionally, the power supply switching circuit may further include a fifth field effect transistor, a gate of the fifth field effect transistor is connected to a control signal, a source of the fifth field effect transistor is connected to the second power supply, and a drain of the fifth field effect transistor is connected to an output of the voltage conversion unit by using a first phase inverter and outputs a third conversion signal. The power supply control method may further include: The control signal controls, if the first power supply fails, the fifth field effect transistor to be turned on, to enable the second power supply to be switched to the output of the power supply switching circuit, where the output of the power supply switching circuit is the voltage of the second power supply. The first conversion signal is reconfigured, if the second power supply fails, to enable the second power supply to be switched to the output of the power supply switching circuit, where the output of the power supply switching circuit is the voltage of the second power supply.

It may be understood that any power supply control method for the storage device, the electronic device, and the like provided above may be implemented by the corresponding storage device provided above. Therefore, for beneficial effects that can be achieved by the method, the electronic device, and the like, refer to the beneficial effects in the storage device provided above. Details are not described herein again.

### BRIEF DESCRIPTION OF DRAWINGS

FIG. 1 is a schematic diagram of power supply logic of a memory;
FIG. 2 is a schematic structural diagram of a voltage conversion circuit used by the memory shown in FIG. 1;
FIG. 3 is a schematic diagram of a circuit structure of a bit cell in the memory shown in FIG. 1;
FIG. 4 is a schematic diagram of a circuit structure of a storage device according to an embodiment of this application;
FIG. 5 is a flowchart of a power supply control method for the storage device shown in FIG. 4;
FIG. 6 is a schematic diagram of a circuit structure of a power supply switching circuit according to a first embodiment of this application;
FIG. 7 is a schematic diagram of a circuit structure of a power supply switching circuit according to a second embodiment of this application;
FIG. 8 is a schematic diagram of a circuit structure of a voltage conversion unit in FIG. 7;
FIG. 9 is a schematic diagram of a circuit structure of a power supply switching circuit according to a third embodiment of this application; and
FIG. 10 is a schematic diagram of a circuit structure of a power supply switching circuit according to a fourth embodiment of this application.

### DESCRIPTION OF EMBODIMENTS

The following describes the technical solutions in embodiments of this application with reference to the accompanying drawings in embodiments of this application. Apparently, the described embodiments are some but not all of embodiments of this application.

The terms "first" and "second" mentioned below are merely intended for a purpose of description, and shall not be understood as an indication or implication of relative importance or implicit indication of the number of indicated technical features. Therefore, a feature limited by "first ", "second" and the like may explicitly indicate or implicitly include one or more such features.

It should be noted that the term "example" or "for example" in this application means "used as an example, an illustration, or a description. Any embodiment or design scheme described with "example" or "for example" in this application should not be explained as being more preferred or having more advantages than another embodiment or design scheme. Exactly, use of the word "example", "for example", or the like is intended to present a related concept in a specific manner.

In this application, unless otherwise specified and limited, the term "connection" should be understood in a broad sense. For example, the "connection" may be a fixed connection, a detachable connection, an integration, a direct connection, or an indirect connection by using an intermediate medium. In addition, the term "coupled" may be a manner for realizing the electrical connection of signal transmission. "Coupled" may be a direct electrical connection, or an indirect electrical connection through an intermediary.

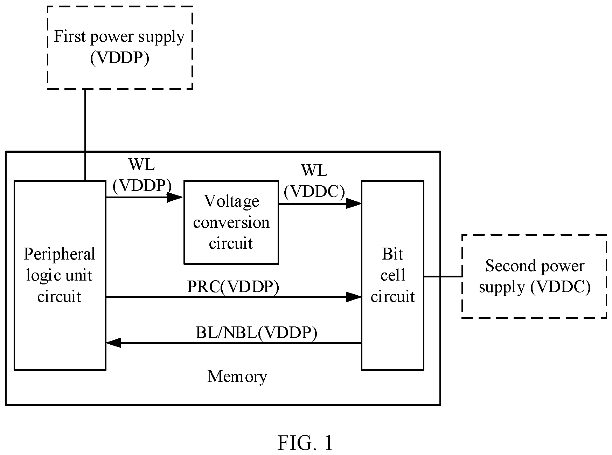

FIG. 1 is a schematic diagram of power supply logic of a memory. As shown in FIG. 1, a memory (memory) may include a peripheral logic (peripheral logic) unit circuit and a bit cell (bit cell) circuit. The peripheral logic unit circuit works in a voltage domain of a first power supply (VDDP), and is powered by the first power supply (VDDP). A voltage range of the first power supply (VDDP) is relatively wide. The bit cell circuit works in a voltage domain of a second power supply (VDDC), and is powered by the second power supply (VDDC). A voltage range of the second power supply (VDDC) is relatively narrow.

In a power supply design solution of the memory, signal interaction and voltage conversion exist between a peripheral logic unit circuit and a bit cell circuit. That is, there is conversion from the voltage domain of the first power supply (VDDP) to the voltage domain of the second power supply (VDDC), or conversion from the voltage domain of the second power supply (VDDC) to the voltage domain of the first power supply (VDDP) between the peripheral logic unit circuit and the bit cell circuit.

For the conversion from the voltage domain of the first power supply (VDDP) to the voltage domain of the second power supply (VDDC): Both an input signal (for example, a WL signal) and an output signal (for example, a BL/NBL signal) of the memory work in the voltage domain of the first power supply (VDDP). Specifically, in the peripheral logic unit circuit, a corresponding word line (word line), that is, a WL (VDDP) signal, is selected for an address and data through decoding and the like. The WL (VDDP) signal converts, by using a voltage conversion circuit (levelshift), an input signal of the voltage domain of the first power supply (VDDP) to a word line of the voltage domain of the second power supply (VDDC), that is, a WL (VDDC) signal, and then a bit cell is accessed to complete a read/write operation in one cycle.

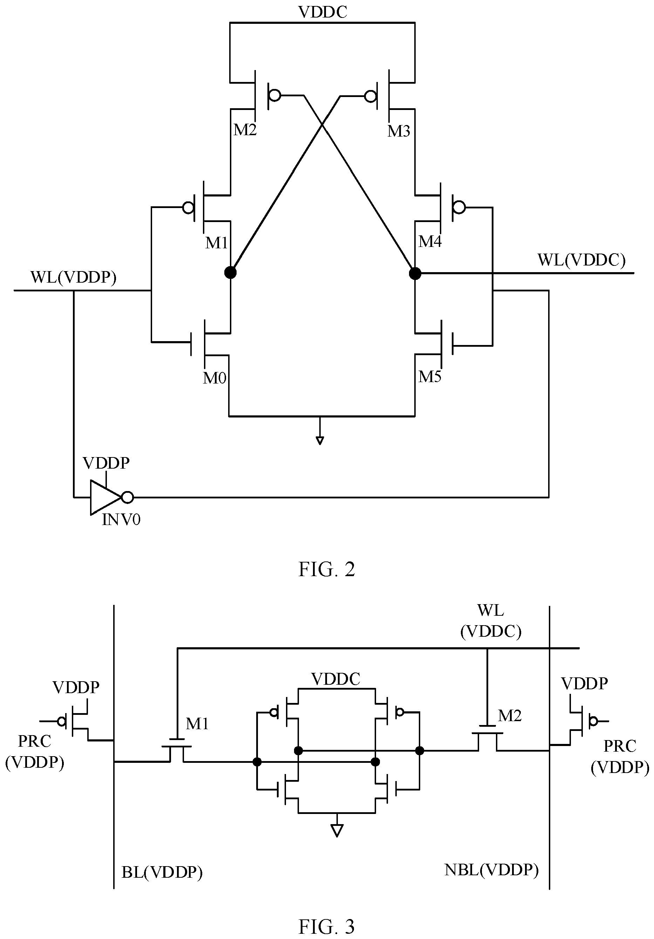

FIG. 2 is a schematic structural diagram of a voltage conversion circuit used by the memory shown in FIG. 1. As shown in FIG. 2, the voltage conversion circuit is implemented by combining a P-metal-oxide-semiconductor (p-metal-oxide-semiconductor, PMOS) and an N-metal-oxide-semiconductor (n-metal-oxide-semiconductor, NMOS).

Specifically, the voltage conversion circuit includes a first NMOS transistor M0, a first PMOS transistor M1, a second PMOS transistor M2, a third PMOS transistor M3, a fourth PMOS transistor M4, a second NMOS transistor M5, and a phase inverter INV0. A gate (gate, G) of the first NMOS transistor M0, a gate of the first PMOS transistor M1, and an input of the phase inverter INV0 are all connected to an input signal of the memory, for example, a word line WL (VDDP) signal, and the input signal works in the voltage domain of the first power supply (VDDP). An output of the phase inverter INV0 is connected to a gate of the fourth PMOS transistor M4 and a gate of the second NMOS transistor M5. A drain of the first NMOS transistor M0 and a drain of the second NMOS transistor M5 are grounded. A source of the first NMOS transistor M0 and a source of the first PMOS transistor M1 are both connected to a gate of the third PMOS transistor M3. A source of the second NMOS transistor M5 and a source of the fourth PMOS transistor M4 are both connected to a gate of the second PMOS transistor M3. A source of the second PMOS transistor M2 and a source of the third PMOS transistor M3 are both connected to the second power supply (VDDC). A drain of the second PMOS transistor M2 is connected to a drain of the first PMOS transistor M1, and a drain of the third PMOS transistor M3 is connected to a drain of the fourth PMOS transistor M4. The source of the second NMOS transistor M5 and the source of the fourth PMOS transistor M4 are further used as output signals of the voltage conversion circuit, for example, word line WL (VDDC) signals, and the output signals work in the voltage domain of the second power supply (VDDC).

Corresponding to the voltage conversion circuit in FIG. 2, when a signal of WL (VDDC) needs to be set to "1", an input signal WL (VDDP) of the voltage conversion circuit is set to "1", that is, a voltage of VDDP. In this case, M0 is turned on, so that M3 is turned on. After the phase inverter is used, M4 is turned on. After M3 and M4 are turned on, VDDC is connected to the output, so that the output is a voltage of the second power supply (VDDC), so that the output of the voltage conversion circuit is a signal "1" in the voltage domain of the second power supply (VDDC), and an output signal of the voltage conversion circuit is WL (VDDC). Conversely, when the signal of WL (VDDC) needs to be set to "0", the input signal of the voltage conversion circuit is set to "0", so that the output signal of the voltage conversion circuit is "0", that is, the WL (VDDC) signal is "0". Therefore, the voltage conversion circuit (levelshift) converts a word line WL (VDDP) signal of the input of the first voltage domain into a word line WL (VDDC) signal of the voltage domain of the second power supply (VDDC).

For the conversion from the second voltage domain (VDDC) to the first voltage domain (VDDP): The bit cell circuit includes a voltage conversion circuit from the voltage domain of the second voltage (VDDC) to the voltage domain of the first power supply (VDDP). Data reading and writing are both reading data inside the bit cell or writing data input externally by using a bit line (bit line, BL). The bit line BL works in the voltage domain of the first power supply (VDDP), and the word line (word line, WL) of the bit cell circuit works in the voltage domain of the second power supply (VDDC).

FIG. 3 is a schematic diagram of a circuit structure of a bit cell in the memory shown in FIG. 1. As shown in FIG. 3, before data is read from the bit cell, a bit line signal (that is, a BL/NBL signal) is charged to the voltage of the first power supply (VDDP) by using a precharge (precharge, PRC) signal, that is, a PRC (VDDP) signal, from the peripheral logic unit circuit. After charging of the BL/NBL signal ends, the WL (VDDC) signal output by the peripheral logic unit circuit is set to "1" to indicate the bit cell circuit to read data, so that the two NMOS transistors (for example, M1 and M2 in FIG. 3) connected to the WL (VDDC) signal are turned on. In this case, in a normal case, the data in the bit cell may be read through the BL/NBL (VDDP) signal, and output to the peripheral logic unit circuit. When the data is read, the BL (VDDP) signal and the NBL (VDDP) signal are a pair of opposite signals that appear in pairs. When the BL (VDDP) signal is "1", the NBL (VDDP) signal is "0". Conversely, when the BL (VDDP) signal is "0", the NBL (VDDP) signal is "1". However, if a voltage difference between the voltage of the first power supply (VDDP) and the voltage of the second power supply (VDDC) is excessively large, data "0" in the bit cell is rewritten to "1", resulting in data overturning and data loss. This phenomenon can be referred to as read disturb (read disturb).

To avoid a read disturb phenomenon, the voltage difference between two power supplies in the memory that uses a dual voltage domain for power supply cannot be excessively large, that is, the voltage difference between the first power supply (VDDP) and the second power supply (VDDC) cannot be excessively large. Therefore, it is relatively difficult to implement a high frequency requirement in a high-performance application by increasing the voltage of the first power supply (VDDP).

To meet an ultra-wide voltage range of the first power supply (VDDP), that is, a requirement for reducing power consumption at a low voltage, and a requirement for a high frequency and a read/write speed of a memory at a high voltage, and avoid a problem that an area of a chip is increased because a relatively large quantity of second power supplies (VDDC) are disposed, an embodiment of this application provides a storage device. A power supply switching circuit is used to provide a dynamic voltage for a bit cell circuit in the memory.

The following describes this embodiment of this application in detail.

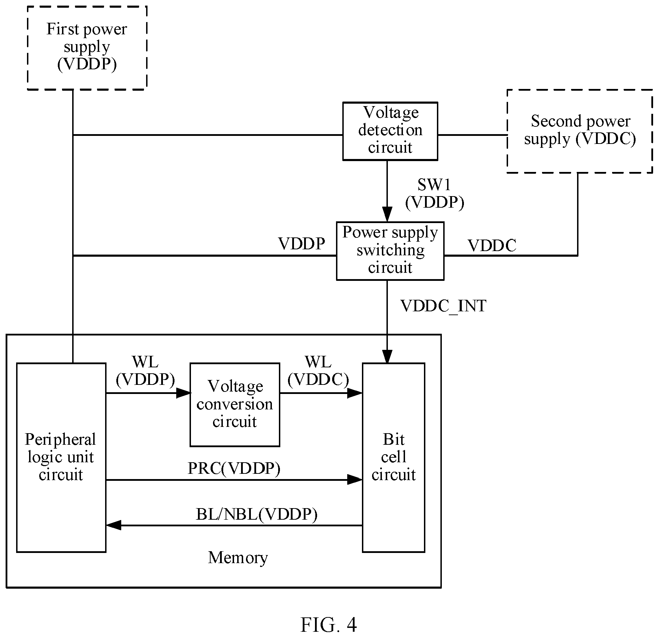

FIG. 4 is a storage device according to an embodiment of this application. The storage device includes a memory, a voltage detection circuit, and a power supply switching circuit configured to supply power to the memory. As shown in FIG. 4, the memory includes a peripheral logic unit circuit and a bit cell circuit. The peripheral logic unit circuit is connected to a first power supply (VDDP), and is powered by the first power supply (VDDP). The bit cell circuit is connected to an output of the power supply switching circuit, that is, a power supply voltage of the bit cell circuit is a power supply voltage obtained by the power supply switching circuit, that is, the bit cell circuit is powered by a dynamic power supply, for example, a power supply of a larger voltage in the first power supply (VDDP) and a second power supply (VDDC) is used to supply power.

More specifically, as shown in FIG. 4, in the foregoing power supply switching circuit, an input of the power supply switching circuit is connected to the voltage detection circuit, and the voltage detection circuit is configured to compare voltages of the first power supply (VDDP) and the second power supply (VDDC), and output a first conversion signal SW1 based on a comparison result. When the voltage of the first power supply (VDDP) is greater than the voltage of the second power supply (VDDC), the first conversion signal SW1 output by the voltage detection circuit is input to the power supply switching circuit, and is used to control the output voltage of the power supply switching circuit to be the first power supply (VDDP). When the voltage of the first power supply (VDDP) is less than the voltage of the second power supply (VDDC), the first conversion signal SW1 output by the voltage detection circuit is input to the power supply switching circuit, and is used to control the output voltage of the power supply switching circuit to be the second power supply (VDDC). For example, when the voltage of the first power supply (VDDP) is greater than the voltage of the second power supply (VDDC), the first conversion signal SW1 may be configured as a digital signal "1", and in this case, an output of the power supply switching circuit is the voltage of the first power supply (VDDP). When the voltage of the first power supply (VDDP) is less than the voltage of the second power supply (VDDC), the first conversion signal SW1 may be configured as a digital signal "0", and in this case, an output of the power supply switching circuit is the voltage of the second power supply (VDDC).

Therefore, when the voltage of the first power supply (VDDP) is greater than the voltage of the second power supply (VDDC), the power supply voltage of the bit cell circuit is the voltage of the first power supply (VDDP). When the voltage of the first power supply (VDDP) is less than the voltage of the second power supply (VDDC), the power supply voltage of the bit cell circuit is the voltage of the second power supply (VDDC).

In this manner, when the voltage of the first power supply (VDDP) is less than the voltage of the second power supply (VDDC), the memory works in a dual voltage domain manner, to meet a power consumption benefit when the voltage of the first power supply (VDDP) is relatively low. When the voltage of the first power supply (VDDP) is greater than the voltage of the second power supply (VDDC), the memory works in a single voltage domain mode, that is, both the peripheral logic unit circuit and the bit cell circuit work under the voltage of the first power supply (VDDP). This can ensure that no read disturb occurs, and can ensure that a read/write speed is improved in a high voltage range, thereby improving performance and reliability of the memory.

It should be understood that the structure in FIG. 4 is merely an example, and the voltage detection circuit and the power supply switching circuit may be included in the memory as a part of the memory. This is not limited in the present invention.

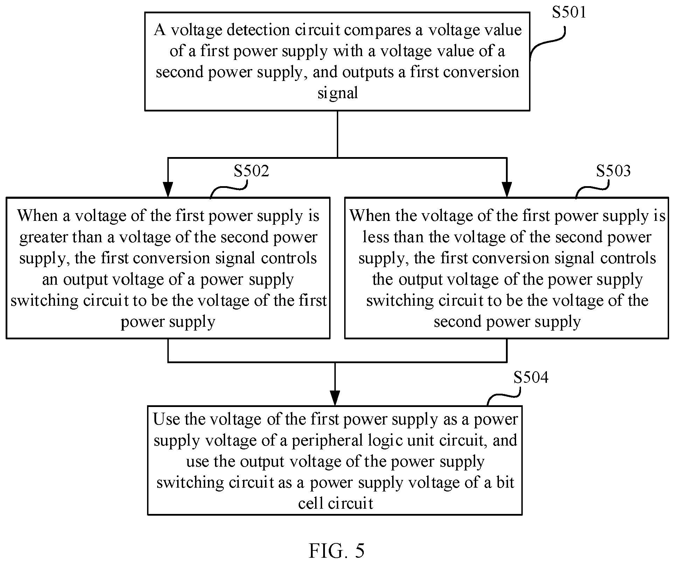

FIG. 5 is a flowchart of a power supply control method for the storage device shown in FIG. 4. As shown in FIG. 5, the power supply control method includes the following steps.

S501. A voltage detection circuit compares a voltage value of a first power supply with a voltage value of a second power supply, and outputs a first conversion signal.

For example, when the voltage value of the first power supply is greater than the voltage value of the second power supply, the first conversion signal may be a digital signal "1". When the voltage value of the first power supply is less than the voltage value of the second power supply, the first conversion signal may be a digital signal "0".

S502. When a voltage of the first power supply is greater than a voltage of the second power supply, the first conversion signal controls an output voltage of a power supply switching circuit to be the voltage of the first power supply.

That is, when the first conversion signal is the digital signal "1", the output voltage of the power supply switching circuit may be controlled to be the voltage of the first power supply.

S503. When the voltage of the first power supply is less than the voltage of the second power supply, the first conversion signal controls the output voltage of the power supply switching circuit to be the voltage of the second power supply.

That is, when the first conversion signal is the digital signal "0", the output voltage of the power supply switching circuit may be controlled to be the voltage of the second power supply.

S504. Use the voltage of the first power supply as a power supply voltage of a peripheral logic unit circuit, and use the output voltage of the power supply switching circuit as a power supply voltage of the bit cell circuit.

In this way, the power supply requirement in FIG. 4 can be implemented, and details are not described herein again.

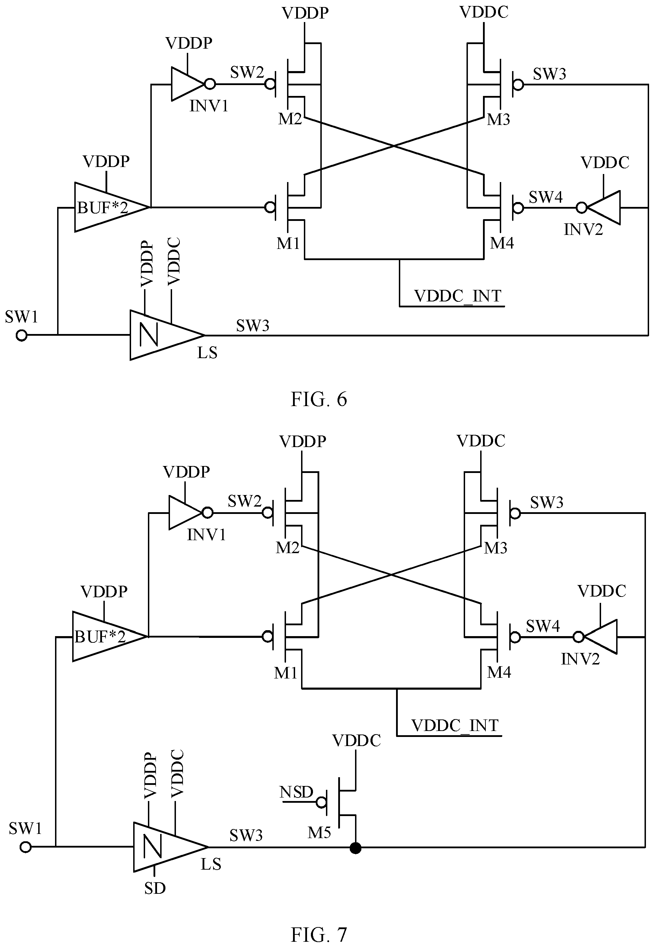

FIG. 6 is a schematic diagram of a circuit structure of a power supply switching circuit according to a first embodiment of this application. The power supply switching circuit is intended to implement the following functions: When the voltage of the first power supply (VDDP) is greater than the voltage of the second power supply (VDDC), the input first conversion signal controls the output voltage of the power supply switching circuit to be the voltage of the first power supply (VDDP); and when the voltage of the first power supply (VDDP) is less than the voltage of the second power supply (VDDC), the input first conversion signal controls the output voltage of the power supply switching circuit to be the voltage of the second power supply (VDDC).

As shown in FIG. 6, the power supply switching circuit may include a first field effect transistor M1, a second field effect transistor M2, a third field effect transistor M3, a fourth field effect transistor M4, and a voltage conversion unit (levelshift, LS). The following describes a connection manner of each component in the power supply switching circuit by using an example in which the first field effect transistor M1, the second field effect transistor M2, the third field effect transistor M3, and the fourth field effect transistor M4 are all implemented by using PMOS transistors.

A drain (drain, D) of the second field effect transistor M2 is connected to a source of the fourth field effect transistor M4, and a drain of the third field effect transistor M3 is connected to a source of the first field effect transistor M1.

A source (source, S) of the second field effect transistor M2 is connected to a first power supply (VDDP), and a source of the third field effect transistor M3 is connected to a second power supply (VDDC). A drain of the first field effect transistor M1 and a drain of the fourth field effect transistor M4 are both connected to the output of the power supply switching circuit, that is, the drain of the first field effect transistor M1 and the drain of the fourth field effect transistor M4 are both used as the output (VDDC_INT) of the power supply switching circuit.

In this case, when the voltage of the first power supply (VDDP) is greater than the voltage of the second power supply (VDDC), the first field effect transistor M1 is controlled to be turned off, the second field effect transistor M2 is controlled to be turned on, the third field effect transistor M3 is controlled to be turned off, and the fourth field effect transistor M4 is controlled to be turned on. The first power supply (VDDP) may be switched to the output (VDDC_INT) of the power supply switching circuit by using the second field effect transistor M2 and the fourth field effect transistor M4, that is, an output voltage (VDDC _INT) of the power supply switching circuit is the voltage of the first power supply (VDDP).

When the voltage of the first power supply (VDDP) is less than the voltage of the second power supply (VDDC), the first field effect transistor M1 is controlled to be turned on, the second field effect transistor M2 is controlled to be turned off, the third field effect transistor M3 is controlled to be turned on, and the fourth field effect transistor M4 is controlled to be turned off. The second power supply (VDDC) may be switched to the output (VDDC_INT) of the power supply switching circuit by using the first field effect transistor M1 and the third field effect transistor M3, that is, an output voltage (VDDC _INT) of the power supply switching circuit is the voltage of the second power supply (VDDC).

Optionally, in the power supply switching circuit shown in FIG. 6, the first conversion signal SW1 is used as an input signal of the power supply switching circuit. A gate (gate, G) of the first field effect transistor M1 is connected to the first conversion signal SW1, a gate of the second field effect transistor M2 is connected to a second conversion signal SW2, a gate of the third field effect transistor M3 is connected to a third conversion signal SW3, and a gate of the fourth field effect transistor M4 is connected to a fourth conversion signal SW4. In this case, the first conversion signal SW1 may control connection and disconnection of the first field effect transistor M1, the second conversion signal SW2 may control connection and disconnection of the second field effect transistor M2, the third conversion signal SW3 may control connection and disconnection of the third field effect transistor M3, and the fourth conversion signal SW4 may control connection and disconnection of the fourth field effect transistor M4.

The first to the fourth field effect transistors M1 to M4 in the power supply switching circuit in FIG. 6 are not limited thereto, and either of NMOS and PMOS may also be used, as long as corresponding turn-off or turn-on of the field effect transistors M1 to M4 in the foregoing two cases is implemented.

With reference to the power supply switching circuit shown in FIG. 6, in the power supply control method shown in FIG. 5, to enable the first conversion signal to control the output voltage of the power supply switching circuit to be the voltage of the first power supply, the method may include: The first conversion signal controls the first field effect transistor to be turned off, the second conversion signal controls the second field effect transistor to be turned on, the third conversion signal controls the third field effect transistor to be turned off, and the fourth conversion signal controls the fourth field effect transistor to be turned on. In this case, the first conversion signal SW1 is a digital signal "1". Based on the power supply switching circuit shown in FIG. 6, the second conversion signal SW2 is "0", the third conversion signal SW3 is "1", and the fourth conversion signal SW4 is "0". The first field effect transistor M1 and the third field effect transistor M3 are turned off, and the second field effect transistor M2 and the fourth field effect transistor M4 are turned on, so that the first power supply (VDDP) is switched to the output of the power supply switching circuit, to enable that an output of the power supply switching circuit is the voltage of the first power supply (VDDP).

Correspondingly, that the first conversion signal controls the output voltage of the power supply switching circuit to be the voltage of the second power supply may include: the first conversion signal controls the first field effect transistor to be turned on, the second conversion signal controls the second field effect transistor to be turned off, the third conversion signal controls the third field effect transistor to be turned on, and the fourth conversion signal controls the fourth field effect transistor to be turned off. The second power supply is switched to the output of the power supply switching circuit, to enable the output of the power supply switching circuit to be the voltage of the second power supply. In this case, the first conversion signal SW1 is a digital signal "0". Based on the power supply switching circuit shown in FIG. 6, the second conversion signal is "1", the third conversion signal is "0", and the fourth conversion signal is "1". The first field effect transistor M1 and the third field effect transistor M3 are turned on, and the second field effect transistor M2 and the fourth field effect transistor M4 are turned off, so that the second power supply (VDDC) is switched to the output of the power supply switching circuit, to enable an output of the power supply switching circuit to be the voltage of the second power supply (VDDC).

Optionally, the first conversion signal SW1 may obtain the third conversion signal SW3 by using the voltage conversion unit LS. In this process, the voltage conversion unit LS changes only a voltage domain in which the first conversion signal SW1 works, but does not change a signal value of the first conversion signal SW1. That is, the first conversion signal SW1 may be converted from a voltage domain of the first power supply (VDDP) to a voltage domain of the second power supply (VDDC) through the voltage conversion unit LS, to obtain the third conversion signal SW3. Therefore, level values of the first conversion signal SW1 and the third conversion signal SW3 are the same, that is, when the first conversion signal SW1 is the digital signal "1", the third conversion signal SW3 is also the digital signal "1", and vice versa.

For the second conversion signal SW2 and the fourth conversion signal SW4, the second conversion signal SW2 is a phase-inverted signal of the first conversion signal SW1. That is, it is assumed that when the first conversion signal SW1 is the digital signal "1", the second conversion signal SW2 is the digital signal "0", and vice versa. The fourth conversion signal SW4 is a phase-inverted signal of the third conversion signal SW3. That is, it is assumed that when the third conversion signal SW3 is the digital signal "1", the fourth conversion signal SW4 is the digital signal "0", and vice versa.

With reference to an actual requirement of the storage device, to avoid an increase in an area of a chip of the storage device caused by setting a relatively large quantity of second power supplies (VDDC), the voltage of the second power supply (VDDC) may be set to a fixed voltage value, for example, 0.8 volts (V). The voltage of the first power supply (VDDP) may be a dynamically changing voltage, to meet a power consumption benefit when the voltage of the first power supply (VDDP) is relatively low and a high frequency requirement when the voltage of the first power supply (VDDP) is relatively high.

The following describes a specific principle of this embodiment of this application by using an example in which the voltage of the second power supply (VDDC) is 0.8 V

For example, referring to FIG. 6, with reference to FIG. 4, when a requirement of low power consumption of a memory needs to be met, a voltage of a first power supply (VDDP) is configured to be less than the voltage 0.8 V of a second power supply (VDDC). In this case, the first conversion signal SW1 output by the voltage detection circuit is "0", and the third conversion signal SW3 output after the first conversion signal SW1 is converted by the voltage conversion unit LS is also "0"; correspondingly, the second conversion signal SW2 is "1", and the fourth conversion signal SW4 is "1". Therefore, the first field effect transistor M1 and the third field effect transistor M3 are turned on, and the second field effect transistor M2 and the fourth field effect transistor M4 are turned off. A path from the second power supply (VDDC) to the output (VDDC_INT) of the power supply switching circuit in FIG. 6 is conductive, and a voltage of the output (VDDC_INT) of the power supply switching circuit is equal to the voltage of the second power supply (VDDC).

In this case, the memory works in a dual voltage domain mode, that is, the peripheral logic unit circuit of the memory works in a voltage domain of the first power supply (VDDP), and the bit cell circuit works in a voltage domain of the second power supply (VDDC). In this way, power consumption of the peripheral logic unit circuit in the memory can be reduced.

When the voltage of the first power supply (VDDP) is equal to the voltage 0.8 V of the second power supply (VDDC), in this case, the first conversion signal SW1 output by the voltage detection circuit may be "0" or "1". In this case, for control logic of the power supply switching circuit, reference may be made to control logic when the first conversion signal is "0" or "1", and details are not described herein again.

When a requirement of high frequency and high performance needs to be met, the voltage of the first power supply (VDDP) is configured to be greater than the voltage 0.8 V of the second power supply (VDDC). In this case, the first conversion signal SW1 output by the voltage detection circuit is " 1", and the third conversion signal SW3 output after the first conversion signal SW1 is converted by the voltage conversion unit LS is also "1"; correspondingly, the second conversion signal SW2 is "0", and the fourth conversion signal SW4 is "0". Therefore, the first field effect transistor M1 and the third field effect transistor M3 are turned off, and the second field effect transistor M2 and the fourth field effect transistor M4 are turned on. A path from the first power supply (VDDP) to the output (VDDC_INT) of the power supply switching circuit in FIG. 6 is conductive, and a voltage of the output (VDDC _INT) of the power supply switching circuit is equal to the voltage of the first power supply (VDDP).

In this case, the memory works in a single voltage domain mode, that is, both the peripheral logic unit circuit and the bit cell circuit of the memory work in the voltage domain of the first power supply (VDDP). In this way, a voltage boosting and frequency increasing requirement of the peripheral logic unit circuit can be ensured, and read disturb caused when a working voltage of the peripheral logic unit circuit is higher than a working power supply of the bit cell circuit can be avoided, thereby improving performance and reliability of the memory.

Optionally, as shown in FIG. 6, the second conversion signal SW2 may be output by the first conversion signal SW1 through the phase inverter INV1 (that is, a second phase inverter), so that the second conversion signal SW2 is a phase-inverted signal of the first conversion signal SW1; and the fourth conversion signal SW4 may be output by the third conversion signal SW3 through the phase inverter INV2 (that is, a third phase inverter), so that the fourth conversion signal SW4 is a phase-inverted signal of the third conversion signal SW3.

In addition, in FIG. 6, to implement state buffering of the first conversion signal SW1, the power supply switching circuit may further include a buffer BUF, where the buffer BUF may be a two-level buffer, an input of the buffer BUF is connected to the first conversion signal SW1, and an output of the buffer BUF is connected to the input of the phase inverter INV1 (that is, the second phase inverter) or the gate of the first field effect transistor M1. That is, after passing through the buffer BLTF, the first conversion signal SW1 may be directly connected to the gate of the first field effect transistor M1, and after passing through the buffer BLTF, the first conversion signal SW1 may be connected to the gate of the second field effect transistor M2 through the phase inverter INV1 (that is, the second phase inverter).

For the voltage conversion unit LS, a main function of the voltage conversion unit LS is to convert a first conversion signal SW1 input to the power supply switching circuit from a voltage domain of a first power supply (VDDP) to a voltage domain of a second power supply (VDDC). Therefore, the voltage conversion unit LS may use the voltage conversion circuit shown in FIG. 2.

In addition, in FIG. 6, the well potentials of the first field effect transistor M1 and the second field effect transistor M2 are both connected to the first power supply (VDDP), and the well potentials of the third field effect transistor M3 and the fourth field effect transistor M4 are both connected to the second power supply (VDDC). In this way, the well potential division may be simpler, and the area of the circuit chip may be saved.

It should be noted that, in the power supply switching circuit shown in FIG. 6, the well potential of the first field effect transistor M1 or the fourth field effect transistor M4 may not be the highest potential. If the well potential of the first field effect transistor M1 or the fourth field effect transistor M4 is not the highest potential, the PN junction between the well potential of the field effect transistor and the source or the drain may be positively biased, and therefore the leakage (leakage) current is excessively large, and the stability of the power supply switching circuit is reduced.

For example, if the first power supply (VDDP) fails, and the voltage of the second power supply (VDDC) is 0.8 V, the path from the second power supply (VDDC) to the output (VDDC _INT) of the power supply switching circuit is conductive, that is, the output voltage (VDDC _INT) of the power supply switching circuit is the voltage of the second power supply (VDDC). In this case, the well potential of the first field effect transistor M1 is "0", so that a voltage difference between the well potential and the source of the first field effect transistor M1 is excessively large, and a relatively large leakage current occurs, which affects stability of the power supply switching circuit.

FIG. 7 is a schematic diagram of a circuit structure of a power supply switching circuit according to a second embodiment of this application.

To avoid a problem that a relatively large leakage current occurs because a voltage difference between a well potential and a source of the first field effect transistor M1 is excessively large due to a power failure of the first power supply (VDDP), as shown in FIG. 7, a control signal SD may be added to the voltage conversion unit LS. When the first power supply (VDDP) fails, that is, the voltage of the first power supply (VDDP) is zero, the control signal SD may be used, for example, when the control signal SD = "1", the output of the voltage conversion unit LS is always "1", so that the first power supply (VDDP) is connected to the output (VDDC _INT) of the power supply switching circuit, and the output (VDDC_INT) of the power supply switching circuit and the first power supply are in a power-off state synchronously.

Specifically, to enable the output (VDDC _INT) of the power supply switching circuit and the first power supply (VDDP) to be in a power-off state simultaneously when the first power supply (VDDP) fails, a fifth field effect transistor M5 may be added to the power supply switching circuit shown in FIG. 7 on the basis of the power supply switching circuit shown in FIG. 6, for example, a fifth field effect transistor M5 may be added to an output end of the voltage conversion unit LS. For example, the fifth field effect transistor M5 may be implemented by using a PMOS transistor. If the control signal SD is "1", the third conversion signal SW3 is always "1", and the fourth conversion signal SW4 is always "0" (that is, the output of the voltage conversion unit LS is always " 1"), the gate of the fifth field effect transistor M5 is connected to a phase-inverted signal NSD of the control signal SD, and the phase-inverted signal NSD may be obtained by the control signal SD through a phase inverter (not shown in FIG. 7). A source of the fifth field effect transistor M5 is connected to the second power supply (VDDC), and a drain of the fifth field effect transistor M5 is connected to the output end of the voltage conversion unit LS, and outputs a third conversion signal SW3.

In this solution, when the control signal SD is "1", a gate signal of the fifth field effect transistor M5 is "0", and the fifth field effect transistor M5 is turned on. In this case, the voltage of the output end of the voltage conversion unit LS may be the voltage of the second power supply (VDDC), that is, the signal "1" of the voltage domain of the second power supply (VDDC). Conversely, when the control signal SD is "0", the gate signal of the fifth field effect transistor M5 is "1", and the fifth field effect transistor M5 is in the turn-off state, which does not affect the normal conversion signal of the voltage conversion unit LS. In this way, in a case that the control signal SD is "1", the third conversion signal SW3 is always "1", and the third field effect transistor M3 is turned off; the fourth conversion signal SW4 is always "0", and the fourth field effect transistor M4 is turned on, so that the first power supply (VDDP) is connected to the output (VDDC _INT) of the power supply switching circuit, thereby achieving a purpose of the output (VDDC_INT) of the power supply switching circuit being in a power-off state synchronously with the first power supply.

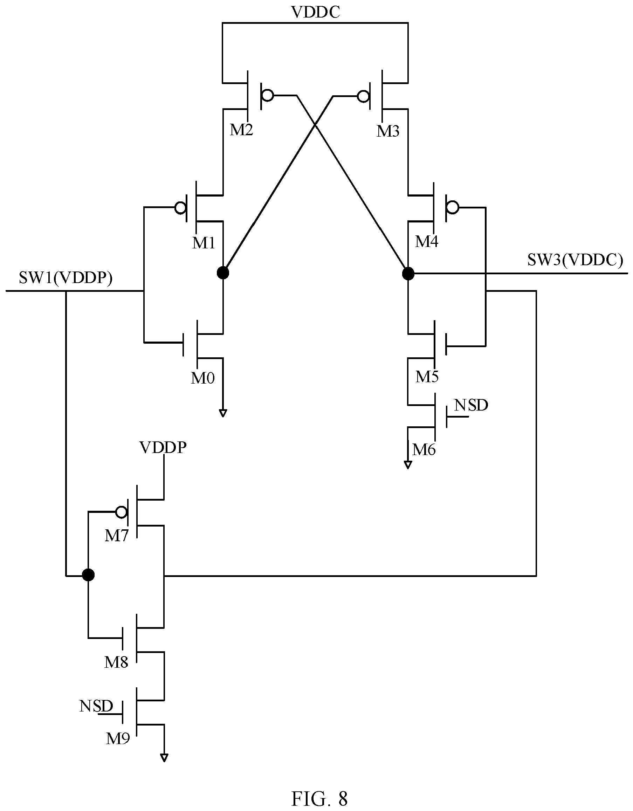

In addition, FIG. 8 is a schematic diagram of a circuit structure of the voltage conversion unit LS in FIG. 7. An input of the voltage conversion unit LS is a first conversion signal SW1, and the first conversion signal SW1 works in a voltage domain of a first power supply (VDDP). To ensure circuit stability of the voltage conversion unit LS when the first power supply (VDDP) fails, a control signal SD may also be added inside the voltage conversion unit LS. Specifically, referring to FIG. 8, a difference from the voltage conversion circuit in FIG. 2 lies in that a third NMOS transistor M6 and a fourth NMOS transistor M9 are added on the basis of the voltage conversion circuit shown in FIG. 2, that is, a third NMOS transistor M6 is added between a drain and a ground of the second NMOS transistor M5, and a gate of the third NMOS transistor M6 is connected to a phase-inverted signal NSD of a control signal SD, and the phase-inverted signal NSD may be obtained by the control signal SD through the phase inverter (not shown in FIG. 8); and a fourth NMOS transistor M9 is added at the ground end of the phase inverter INV0, and a gate of the fourth NMOS transistor M9 is connected to the phase-inverted signal of the control signal SD.

It should be understood that the fifth field effect transistor M5 may be disposed outside the voltage conversion unit LS (as shown in FIG. 7), or may be disposed inside the voltage conversion unit LS. This is not specifically limited in this embodiment of this application.

It should be noted that, based on the power supply switching circuit shown in FIG. 7, the method shown in FIG. 5 may further include: if the first power supply (VDDP) fails, the control signal SD controls the fifth field effect transistor M5 to be turned on, so that the first power supply (VDDP) is switched to the output of the power supply switching circuit, to enable the output of the power supply switching circuit to be the voltage of the first power supply (VDDP).

For a specific implementation process, refer to the related description of the power supply switching circuit shown in FIG. 7. Details are not described herein again.

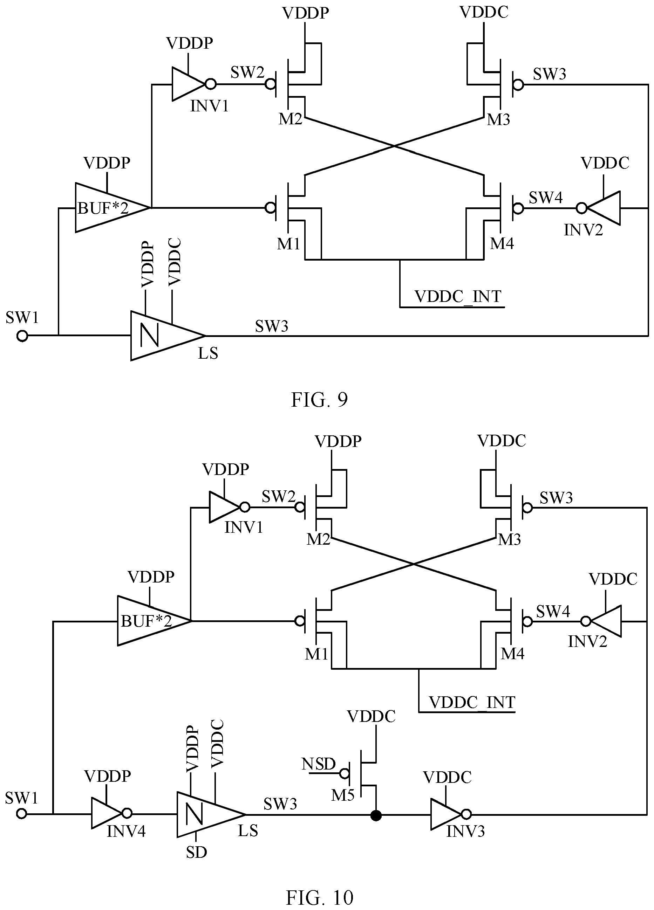

FIG. 9 is a schematic diagram of a circuit structure of a power supply switching circuit according to a third embodiment of this application. With reference to FIG. 6 and referring to FIG. 9, a difference between the power supply switching circuit shown in FIG. 9 and the power supply switching circuit shown in FIG. 6 lies in that the well potential connection positions of the first field effect transistor M1 and the fourth field effect transistor M4 are different. For other connection parts of the power supply switching circuit, refer to FIG. 6, and details are not described herein again.

Specifically, in FIG. 9, the well potential of the first field effect transistor M1 and the well potential of the fourth field effect transistor M4 are both connected to the output (VDDC _INT) of the power supply switching circuit, the well potential of the second field effect transistor M2 is connected to the first power supply (VDDP), and the well potential of the third field effect transistor M3 is connected to the second power supply (VDDC). That is, for the second field effect transistor M2 connected to the first power supply (VDDP) and the third field effect transistor M3 connected to the second power supply (VDDC), the well potentials of the second field effect transistor M2 and the third field effect transistor M3 are respectively connected to the respective power supply, thereby avoiding latch up (latch up) caused by external voltage fluctuation, and improving performance and reliability of the memory. For an intermediate device that is not connected to the power supply (the first power supply or the second power supply), that is, the well potential of the first field effect transistor M1 and the well potential of the fourth field effect transistor M4 are connected to the output (VDDC_INT) of the power supply switching circuit, it can be ensured that the well potential of the first field effect transistor M1 and the well potential of the fourth field effect transistor M4 are always connected to the highest potential of the first power supply (VDDP) and the second power supply (VDDC), in this way, latch up (latch up) that occurs when the well potential of the first field effect transistor M1 and the well potential of the fourth field effect transistor M4 are positively deviated from the PN junctions between the sources and the drains of the first field effect transistor M1 and the fourth field effect transistor M4 is effectively avoided, and performance and reliability of the memory are improved.

FIG. 10 is a schematic diagram of a circuit structure of a power supply switching circuit according to a fourth embodiment of this application. A difference between the power supply switching circuit shown in FIG. 10 and the power supply switching circuit shown in FIG. 9 lies in that, in the power supply switching circuit shown in FIG. 10, a circuit structure that may be used to solve a problem that occurs when either of the first power supply (VDDP) and the second power supply (VDDC) fails is added, for example, a control signal SD is added to a voltage conversion unit LS. For example, when either of the first power supply (VDDP) and the second power supply (VDDC) fails, the following procedure may be performed:

When the first power supply (VDDP) fails, the control signal SD is configured as "1", so that the third conversion signal SW3 is always "0", and the fourth conversion signal SW4 is always "1", so that a path from the output (VDDC _INT) of the first power supply (VDDP) to the power supply switching circuit is turned off through the fourth field effect transistor M4, and a path from the output (VDDC_INT) of the second power supply (VDDC) to the power supply switching circuit is turned on.

When the second power supply (VDDC) fails, the first conversion signal SW1 is configured as "0", so that the third conversion signal SW3 is always "0", and the fourth conversion signal SW4 is always "1", so that a path from the second power supply (VDDC) to the output (VDDC _INT) of the power supply switching circuit is turned on, and the output (VDDC _INT) of the power supply switching circuit and the second power supply (VDDC) are in a power-off state at the same time.

To implement the foregoing process, a fifth field effect transistor M5 may be added to an output end of the voltage conversion unit LS. For an arrangement position of the fifth field effect transistor M5, refer to the description of the fifth field effect transistor M5 in the power supply switching circuit shown in FIG. 7. Details are not described herein again.

Different from FIG. 7, in FIG. 7, when the control signal SD is configured as "1", the third conversion signal SW3 needs to be always "1", and the fourth conversion signal SW4 needs to be always "0"; while in FIG. 10, when the control signal SD is configured as "1", the third conversion signal SW3 needs to be always "0", and the fourth conversion signal SW4 needs to be always "1". Therefore, in this embodiment, a phase inverter INV3 (for example, a first phase inverter) may be added to an output end of the voltage conversion unit LS, and an output of the phase inverter INV3 is used as a final output of the voltage conversion unit LS, so as to meet a requirement that when the control signal SD is "1", the third conversion signal SW3 is always "0", and the fourth conversion signal SW4 is always "1".

Correspondingly, the circuit shown in FIG. 10 should further meet the following condition: In a case that both the first power supply (VDDP) and the second power supply (VDDC) are powered on, when the first conversion signal SW1 is "1", an output of the voltage conversion unit LS is " 1"; and when the first conversion signal SW1 is "0", an output of the voltage conversion unit LS is "0". Therefore, the first conversion signal SW1 may be input to the input end of the voltage conversion unit LS after passing through a phase inverter INV4 (for example, a fourth phase inverter), so as to cancel a signal change caused by the phase inverter INV3 at the output end of the voltage conversion unit LS.

It should be understood that any one of the fifth field effect transistor M5, the phase inverter INV3, and the phase inverter INV4 in the circuit shown in FIG. 10 may be disposed inside the voltage conversion unit LS, or may be disposed outside the voltage conversion unit LS. This is not specifically limited in this embodiment of this application.

For the power supply switching circuit shown in FIG. 10, the power supply switching circuit implements processing of a case in which either the first power supply (VDDP) or the second power supply (VDDC) fails. Corresponding to the power supply control method for the storage device shown in FIG. 5, the method may further includethe following steps.

If the first power supply (VDDP) fails, the control signal SD controls the fifth field effect transistor M5 to be turned on, so that the second power supply (VDDC) is switched to the output of the power supply switching circuit, and the output of the power supply switching circuit is the voltage of the second power supply (VDDC).

If the second power supply (VDDC) fails, the first conversion signal SW1 is reconfigured, so that the second power supply (VDDC) is switched to the output of the power supply switching circuit, and the output of the power supply switching circuit is the voltage of the second power supply (VDDC).

For a specific process, refer to the related description of the power supply switching circuit shown in FIG. 10. Details are not described herein again.

It should be noted that the field effect transistors in the various different power supply switching circuits provided in this embodiment of this application may also be replaced with other switching components that have a control signal end, such as a triode. These should also fall within the protection scope of this application.

An embodiment of this application further provides an electronic device. The electronic device includes electronic products such as a mobile phone (mobile phone), a pad (pad), a computer, an intelligent wearable product (for example, a smartwatch or a smart band), a virtual reality (virtual reality, VR) terminal device, and an augmented reality (augmented reality, AR) terminal device. A specific form of the electronic device is not specifically limited in the embodiment of this application.

The electronic device may include a storage device and a processor. The processor is coupled to the storage device, for example, may be connected by using a communication bus. The storage device may be the storage device shown in FIG. 4.

It should be understood that, the processor in embodiments of this application may be a central processing unit (central processing unit, CPU), or may be another general-purpose processor, a digital signal processor (digital signal processor, DSP), an application specific integrated circuit (application specific integrated circuit, ASIC), a field programmable gate array (field programmable gate array, FPGA) or another programmable logic device, a discrete gate or transistor logic device, a discrete hardware component, or the like. The general purpose processor may be a microprocessor, or the processor may be any conventional processor or the like.

It may be further understood that the memory in embodiments of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM) that is used as an external cache. Through example but not limitative description, many forms of random access memories (random access memories, RAMs) may be used, for example, a static RAM (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM).

In the several embodiments provided in this application, it should be understood that the disclosed circuit and method may be implemented in other manners. For example, the described circuit embodiment is merely an example. For example, division into modules or units is merely logical function division and may be other division in actual implementation. For example, a plurality of units or components may be combined or integrated into another apparatus, or some features may be ignored or not performed.

The units described as separate parts may or may not be physically separate, and parts displayed as units may be one or more physical units, may be located in one place, or may be distributed on different places. Some or all of the units may be selected based on actual requirements to achieve the objectives of the solutions of embodiments.

Various embodiments of a method are provided in the present invention. In various embodiments, one or more operations of the method may be controlled or managed by software, firmware, hardware, or any combination thereof, but is not limited thereto. The method may include processes of embodiments of the present disclosure, which may be controlled or managed by a processor and/or a computing device under the control of a computer or computing device readable and executable instructions (or code). The computer or computing device readable and executable instructions (or code) may reside in, for example, a data storage apparatus, such as a computer or computing device that may use volatile memory, a computer or computing device that may use non-volatile memory, and/or a computer or computing device that may use massive data storage. The computer or computing device readable and executable instructions (or code) may also reside in any type of computer or computing device readable medium or memory. When a computer program, a computer-readable instruction, or code is executed on a processor and/or a computing device, the methods in embodiments of this application are performed.

The methods or processes of various embodiments described above may be discussed in a general context residing in computer-executable instructions (such as some form of computer-readable storage medium of a program module) executed by one or more computers or other devices. As an example, but not limited to, the computer-readable storage medium may include a non-transitory computer storage medium and a communication medium. Generally, a program module includes a routine, a program, an object, a component, a data structure, or the like that executes a specific task or implements a specific abstract data type. In various embodiments, functions of the program module may be combined or split as required.

The computer storage medium includes any volatile and non-volatile, removable and non-removable media that store information such as computer-readable instructions, data structures, program modules, or other data and that are implemented by using any method or technology. The computer storage medium includes but is not limited to a random access memory (RAM), a read-only memory (ROM), an electrically erasable programmable read-only memory (EEPROM), a flash memory or another memory technology, a CD-ROM (CD-ROM), or any other medium that can be used to store required information and can be accessed to retrieve the information.

The communication medium may include a computer-executable instruction, a data structure, and a program module, and include any information transfer medium. As an example, but not limited to, the communication medium includes a wired medium, for example, a wired network or a direct wired connection, and a wireless medium, for example, a sound, a radio frequency (RF), an infrared, and another wireless medium. Any combination of the foregoing may also be included within the scope of a computer-readable storage medium.

Finally, it should be noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A storage device, comprising a voltage detection circuit, a power supply switching circuit, a peripheral logic unit circuit, and a bit cell circuit, wherein
the peripheral logic unit circuit is connected to a first power supply, and the bit cell circuit is connected to an output of the power supply switching circuit;
the voltage detection circuit is connected to the first power supply and a second power supply, and is configured to compare a voltage value of the first power supply with a voltage value of the second power supply, and output a first conversion signal based on a comparison result;
an input of the power supply switching circuit is connected to an output of the voltage detection circuit, and the power supply switching circuit is connected to the first power supply and the second power supply;
when a voltage of the first power supply is greater than a voltage of the second power supply, the first conversion signal is used to control an output voltage of the power supply switching circuit to be the voltage of the first power supply; and
when the voltage of the first power supply is less than the voltage of the second power supply, the first conversion signal is used to control the output voltage of the power supply switching circuit to be the voltage of the second power supply.

2. The storage device according to claim 1, wherein the power supply switching circuit comprises a first field effect transistor, a second field effect transistor, a third field effect transistor, and a fourth field effect transistor;
a drain of the second field effect transistor is connected to a source of the fourth field effect transistor, and a drain of the third field effect transistor is connected to a source of the first field effect transistor;
a source of the second field effect transistor is connected to the first power supply, and a source of the third field effect transistor is connected to the second power supply;
both a drain of the first field effect transistor and a drain of the fourth field effect transistor are connected to the output of the power supply switching circuit;
when the voltage of the first power supply is greater than the voltage of the second power supply, the first field effect transistor is controlled to be turned off, the second field effect transistor is controlled to be turned on, the third field effect transistor is controlled to be turned off, and the fourth field effect transistor is controlled to be turned on; and
when the voltage of the first power supply is less than the voltage of the second power supply, the first field effect transistor is controlled to be turned on, the second field effect transistor is controlled to be turned off, the third field effect transistor is controlled to be turned on, and the fourth field effect transistor is controlled to be turned off.

3. The storage device according to claim 2, wherein a gate of the first field effect transistor is connected to the first conversion signal output by the voltage detection circuit, a gate of the second field effect transistor is connected to a second conversion signal, a gate of the third field effect transistor is connected to a third conversion signal, and a gate of the fourth field effect transistor is connected to a fourth conversion signal; and the third conversion signal is obtained by converting the first conversion signal from a voltage domain of the first power supply to a voltage domain of the second power supply by using a voltage conversion unit, the second conversion signal is a phase-inverted signal of the first conversion signal, and the fourth conversion signal is a phase-inverted signal of the third conversion signal.

4. The storage device according to claim 3, wherein well potentials of the first field effect transistor and the second field effect transistor are both connected to the first power supply; and
well potentials of the third field effect transistor and the fourth field effect transistor are both connected to the second power supply.

5. The storage device according to claim 3, wherein well potentials of the first field effect transistor and the fourth field effect transistor are both connected to the output of the power supply switching circuit;
a well potential of the second field effect transistor is connected to the first power supply; and
a well potential of the third field effect transistor is connected to the second power supply.

6. The storage device according to claim 4, wherein the power supply switching circuit further comprises a fifth field effect transistor, a gate of the fifth field effect transistor is connected to a control signal, a source of the fifth field effect transistor is connected to the second power supply, and a drain of the fifth field effect transistor is connected to an output of the voltage conversion unit; and
if the first power supply fails, the control signal is used to control the fifth field effect transistor to be turned on, to enable the output voltage of the power supply switching circuit to be the voltage of the first power supply.

7. The storage device according to claim 5, wherein the power supply switching circuit further comprises a fifth field effect transistor, a gate of the fifth field effect transistor is connected to a control signal, a source of the fifth field effect transistor is connected to the second power supply, and a drain of the fifth field effect transistor is connected to an output of the voltage conversion unit by using a first phase inverter; and
if the first power supply fails, the control signal is used to control the fifth field effect transistor to be turned on, to enable the output voltage of the power supply switching circuit to be the voltage of the second power supply.

8. The storage device according to claim 3, wherein the second conversion signal is output by a second phase inverter based on the first conversion signal.

9. The storage device according to claim 3, wherein the fourth conversion signal is output by a third phase inverter based on the third conversion signal.

10. The storage device according to claim 8, wherein the power supply switching circuit further comprises a buffer, wherein an input of the buffer is connected to the first conversion signal, and an output of the buffer is connected to an input of the second phase inverter or the gate of the first field effect transistor.

11. An electronic device, comprising a storage device and a processing chip, wherein the storage device is coupled to the processing chip, and the storage device is the storage device according to any one of claims 1 to 10.

12. A power supply control method for a storage device, wherein the method is applicable to the storage device according to any one of claims 1 to 10; and
the method comprises:
comparing, by the voltage detection circuit, a voltage value of the first power supply with a voltage value of the second power supply, and outputting a first conversion signal;
controlling, by the first conversion signal, when a voltage of the first power supply is greater than a voltage of the second power supply, an output voltage of the power supply switching circuit to be the voltage of the first power supply;
controlling, by the first conversion signal, when the voltage of the first power supply is less than the voltage of the second power supply, the output voltage of the power supply switching circuit to be the voltage of the second power supply; and
using the voltage of the first power supply as a power supply voltage of the peripheral logic unit circuit; and using the output voltage of the power supply switching circuit as a power supply voltage of the bit cell circuit.

13. The power supply control method according to claim 12, wherein the power supply switching circuit comprises: a first field effect transistor, a second field effect transistor, a third field effect transistor, and a fourth field effect transistor;
a gate of the first field effect transistor is connected to the first conversion signal output by the voltage detection circuit, a gate of the second field effect transistor is connected to a second conversion signal, a gate of the third field effect transistor is connected to a third conversion signal, and a gate of the fourth field effect transistor is connected to a fourth conversion signal;
a drain of the second field effect transistor is connected to a source of the fourth field effect transistor, and a drain of the third field effect transistor is connected to a source of the first field effect transistor;
a source of the second field effect transistor is connected to the first power supply, and a source of the third field effect transistor is connected to the second power supply;
both a drain of the first field effect transistor and a drain of the fourth field effect transistor are connected to the output of the power supply switching circuit;
the controlling, by the first conversion signal, an output voltage of the power supply switching circuit to be the voltage of the first power supply comprises:
controlling, by the first conversion signal, the first field effect transistor to be turned off, controlling, by the second conversion signal, the second field effect transistor to be turned on, controlling, by the third conversion signal, the third field effect transistor to be turned off, and controlling, by the fourth conversion signal, the fourth field effect transistor to be turned on, so that
the first power supply is switched to the output of the power supply switching circuit, to enable the output of the power supply switching circuit to be the voltage of the first power supply; and
the controlling, by the first conversion signal, the output voltage of the power supply switching circuit to be the voltage of the second power supply comprises:
controlling, by the first conversion signal, the first field effect transistor to be turned on, controlling, by the second conversion signal, the second field effect transistor to be turned off, controlling, by the third conversion signal, the third field effect transistor to be turned on, and controlling, by the fourth conversion signal, the fourth field effect transistor to be turned off, so that
the second power supply is switched to the output of the power supply switching circuit, to enable the output of the power supply switching circuit to be the voltage of the second power supply.

14. The control method according to claim 13, wherein the power supply switching circuit further comprises a fifth field effect transistor, a gate of the fifth field effect transistor is connected to a control signal, a source of the fifth field effect transistor is connected to the second power supply, and a drain of the fifth field effect transistor outputs a third conversion signal; and
the control method further comprises:
controlling, by the control signal if the first power supply fails, the fifth field effect transistor to be turned on, to enable the first power supply to be switched to the output of the power supply switching circuit, wherein the output of the power supply switching circuit is the voltage of the first power supply.

15. The control method according to claim 13, wherein the power supply switching circuit further comprises a fifth field effect transistor, a gate of the fifth field effect transistor is connected to a control signal, a source of the fifth field effect transistor is connected to the second power supply, and a drain of the fifth field effect transistor outputs a third conversion signal by using a first phase inverter; and
the control method further comprises:
controlling, by the control signal, if the first power supply fails, the fifth field effect transistor to be turned on, to enable the second power supply to be switched to the output of the power supply switching circuit, wherein the output of the power supply switching circuit is the voltage of the second power supply; or
reconfiguring the first conversion signal if the second power supply fails, to enable the second power supply to be switched to the output of the power supply switching circuit, wherein the output of the power supply switching circuit is the voltage of the second power supply.

16. A computer-readable storage medium, wherein the computer-readable storage medium comprises a computer program, a computer-readable instruction, or code, and when the computer program, the computer-readable storage medium, or the code is executed on a processor, the method according to any one of claims 12 to 15 is performed.
